# EUROPEAN PATENT APPLICATION

(11) **EP 4 465 343 A1**
(43) Date of publication of application: **20.11.2024**
(21) Application number: 22920558.8
(22) Date of filing: 15.12.2022
(51) Int. Cl.: H01L 21/304, B23H 5/08

(54) **SURFACE PROCESSING METHOD OF SEMICONDUCTOR WAFER**

(30) Priority: 14.01.2022 JP 2022004601
(71) Applicant: DENSO CORPORATION, Kariya-city, Aichi 448-8661 (JP)
(72) Inventor: MARUNO, Naoki, Kariya-city, Aichi 4488661 (JP); AOKI, Kazufumi, Kariya-city, Aichi 4488661 (JP); SOLTANI, Bahman, Kariya-city, Aichi 4488661 (JP); FURUKAWA, Ryuta, Kariya-city, Aichi 4488661 (JP)
(74) Representative: Kuhnen & Wacker Patent- und Rechtsanwaltsbüro PartG mbB
(86) International application number: PCT/JP2022/046210
(87) International publication number: WO 2023/136040

(57) **Abstract**

A surface processing method of a semiconductor wafer (W) includes the following processes, procedures or steps: a pulsed current of which the current density is larger than or equal to 20mA/cm² is caused to flow through the semiconductor wafer (W) as an anode in an electrolyte solution (S), thereby anodizing an object surface (W1) of the semiconductor wafer; and in a state where a surface processing pad (3) having a grinding stone layer (32) is disposed such that the grinding stone layer faces the object surface, an oxide generated by the anodization is selectively removed by the grinding stone layer.

## Description

### [CROSS-REFERENCE TO RELATED APPLICATION]

The present application claims the benefit of priority based on Japanese Patent Application No. 2022-4601 filed on January 14, 2022, the entire disclosure of which is incorporated herein by reference.

### [Technical Field]

The present disclosure relates to a surface processing method.

### [Background Art]

PTL1 discloses a polishing method being applied with an anodization in which a working-resistant material such as single crystal SiC is processed to be a target shape having a high-quality surface that is scratch- free and damage-free. Specifically, the polishing method disclosed by PTL1 includes an anodization process and a polishing process. In the anodization process, a voltage is applied to an object to be processed (i.e. workpiece) as an anode in an electrolyte solution to cause a current having a predetermined current density to flow, thereby forming an oxide film on the surface of the workpiece. In the polishing process, a polishing material is utilized having a Mohs hardness of an intermediate value between the hardness of the material to be processed and the hardness of the oxide film, and the oxide film is selectively removed by polishing. According to the polishing method disclosed by PTL1, the anodization process and the polishing process are caused to simultaneously proceed, thereby planarizing the surface of the workpiece. Note that the polishing method disclosed by PTL1 is included in a technique referred to as ECMP. ECMP is an abbreviation of Electro-Chemical Mechanical Polishing.

### [Citation List]

### [Patent Literature ]

[PTL1] JP-A-2017-92497

### [Summary of the Invention]

The electrical resistance varies in the semiconductor wafer. Specifically, in the semiconductor wafer, a low resistance region referred to as a facet region may be formed. The facet region is formed such that the larger the wafer size, the more likely facet regions are to be produced, and the larger the size of the regions. In this respect, according to the above-described conventional polishing method being applied with the anodization process, if current is concentrated at a facet region having low resistance, the oxidation rate is faster than that of other regions, causing an increase in the thickness of the oxidation film. Then, the oxide film is not completely removed and remains in the facet region, which may cause a defective finished surface of the wafer (i.e. oxidation residue or defective shape). On the other hand, in order to prevent a residue of the oxide film from being produced in facet regions, the polishing rate may be increased. However, a process-modified layer may be produced as a surface layer having strain or scratching in the crystal structure. The present disclosure has been achieved in light of the above-described circumstances. That is, the present disclosure provides a technique capable achieving process characteristics better than a conventional technique in a surface processing method of semiconductor wager utilizing anodization for example.

According to one aspect of the present disclosure, a method for processing a surface of a semiconductor wafer includes steps of: causing a pulsed current of which the current density is larger than or equal to 20mA/cm² to flow through the semiconductor wafer as an anode in an electrolyte solution, thereby anodizing an object surface; and selectively removing an oxide generated on the object surface during the anodization.

Note that reference symbols with parentheses may be applied to respective elements in the respective sections of the specification. In this case, the reference symbols merely indicate relationship between the elements and specific configurations in the embodiments which will be described later. Hence, the present disclosure is not limited thereto even with the reference symbols.

### [Brief Description of Drawings]

[Fig.1] is a diagram showing an overall configuration of a surface processing apparatus for executing a surface processing method according to an embodiment of the present disclosure;
[Fig.2] is a diagram showing an analysis result of a flatness of a wafer surface after polishing is applied according to embodiments and comparative example; and
[Fig.3] is a table showing a residue state of an oxide film after the polishing is applied according to embodiments and comparative example.

### [Description of Embodiments]

### (Embodiments)

Hereinafter, with reference to drawings, embodiments of the present disclosure will be described. Note that various modification examples applicable to one embodiment, if inserted into a middle of series of descriptions for the embodiment, may hinder understanding of the embodiment. Hence, modification examples will not be inserted into a middle of series of descriptions and will be described later.

### (Surface processing apparatus)

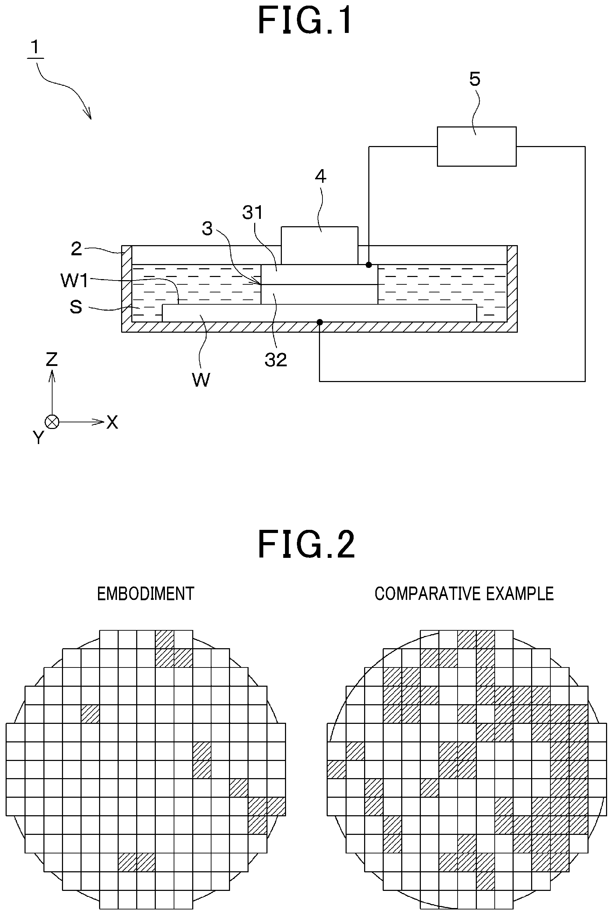

Referring to Fig.1, a surface processing apparatus 1 processes a semiconductor wafer W which is SiC wafer as an object to be processed (i.e. workpiece). The surface processing apparatus 1 is configured to be capable of planarizing, that is, polishing an object surface W1 as a major surface of the semiconductor wafer W. The major surface is a surface orthogonal to a thickness direction of a layered object or plate-like object, and referred to as a plate surface. Specifically, according to the present embodiment, the surface processing apparatus 1 is configured to be capable of performing a polishing process utilizing an anodization applied to the object surface W1. That is, the surface processing apparatus 1 includes a configuration as an ECMP apparatus.

The surface processing apparatus 1 is provided with a case 2, a surface processing pad 3, a driving apparatus 4 and a power source apparatus 5. As will be described later, Fig.1 and the following description using Fig.1 are simplified for describing the surface processing method according to the present embodiment, and are not the same as the specific apparatus configuration actually manufactured and sold. Further, in order to simplify the description, a right-handed XYA coordinate system is set. According to the present embodiment, Z-axis positive direction is defined a vertically upward direction, that is, a direction opposite to a wight-action direction. Further, a X-axis direction and a Y-axis direction which cross each other indicate a horizontal direction. Hereinafter, for the sake of convenience, the Z-axis positive direction corresponding to the vertically upward direction is simply referred to upward or the opposite direction thereof is simply referred to as downward.

The case 2 is formed in a bathtub shape which upwardly opens. The case 2 is configured to accommodate the semiconductor wafer W while anodization being applied in an electrolyte solution S containing no etchant component, and hold the semiconductor wafer W at a bottom portion thereof. The etchant component is a component (e.g. hydrofluoric acid) constituting a solution capable of dissolving an oxide film (i.e. SiC oxide formed in a film-shape) formed on the object surface W1 by anodization. The solution S containing no etchant component used in the present embodiment is, for example, a solution of sodium chloride, potassium chloride, sodium nitrate or the like. The surface processing pad 3 and the driving apparatus 4 are arranged in an upper side of the case 2. The case 2, the surface processing pad 3 and the driving apparatus 4 are provided to be capable of being relatively moved in the vertical direction with a lifting mechanism which is not shown. Further, the case 2, the surface processing pad 3 and the driving apparatus 4 are provided to be capable of being relatively moved in an in-plane direction along the object surface W1 (i.e. horizontal direction) with a slide mechanism which is not shown.

The surface processing pad 3 includes an electrode 31 and a grinding stone layer 32. The electrode 31 is a plate-like member composed of a good conductor such as metal, and formed of a copper plate, for example. The grinding stone layer 32 is adjoined to the electrode 31. That is, the surface processing pad 3 includes a configuration in which the electrode 31 and the grinding stone layer 32 adjoin in the thickness direction of the surface processing pad 2. The grinding stone layer 32 is formed of a grinding stone (e.g. cerium-grinding-stone) as a polishing material. The surface processing pad 3 is disposed such that the grinding stone layer 32 faces the object surface W1 across the electrolyte solution S therebetween. Then, the surface processing pad 3 is rotatably driven by the driving apparatus 4 in a state where the grinding stone layer 32 is disposed to face the object surface W1 across the electrolyte solution S, whereby an oxide film generated on the object surface by the anodization is selectively polish-removed.

The driving apparatus 4 is configured to rotatably drive the surface processing pad 3 around the rotation axis extending in the vertical direction. The power source apparatus 5 is provided to apply voltage between the semiconductor wafer W as a workpiece in the electrolyte S as the anode and the surface processing pad 3 as the cathode, thereby causing an anodization current to flow for performing an anodization of the object surface W1 as an object of the grinding stone layer 32.

### (Overview of surface processing method in the embodiment)

A surface processing method (i.e. polishing method) of the semiconductor wafer W according to the present embodiment is performed using the surface processing apparatus 1 shown in Fig.1. Specifically, the polishing method according to the present embodiment includes the following processes (1) to (3) so as to achieve superior processing characteristics compared to conventional ECMP process. Note that an anode oxidation process (2) and an oxidation film selective removing process (3), that is, polishing process can be performed simultaneously or sequentially or alternately.
(1) The semiconductor wafer W and the surface processing pad 3 are arranged being immersed in the electrolyte solution S such that the object surface W1 and the grinding stone layer 32 face each other across the electrolyte solution S.
(2) A pulsed current of which the current density is larger than or equal to 20mA/cm² is caused to flow through the semiconductor wafer W as the anode in a state where the grinding stone layer 32 is disposed to face the object surface W1 under the electrolyte solution S environment, whereby the object surface W1 is anodized. Here, a period of the pulsed current may preferably be 0.5 second to 5.0 second, and the duty ratio of the pulsed current may preferably be 0.5 to 0.9.
(3) The anodized object surface W1 is polished by the surface processing pad 3, that is, the grinding layer 32, thereby selectively removing the oxide film on the object surface W1 (i.e. oxide formed in a film shape).

The inventors of the present disclosure have found a problem in a conventional ECMP process for a SiC wafer as an object to be processed. That is, even when attempting to increase the current density of the anodization current so as to increase the processing speed, the oxidation rate in the anodization is saturated, thereby limiting an increase in the processing speed. According to research by the inventors, the cause of the saturation of an increase in the oxidation rate due to an increase in the current density is considered to be a lack of the supply quantity of reactive species (i.e. OH⁻) in the electrolyte solution S in the vicinity of the object surface W1. Note that a region in the vicinity of the object surface W1 is abbreviated as surface vicinity region hereinafter.

Specifically, with the anodization, OH⁻ is consumed in the surface vicinity region, thereby decreasing a concentration of the OH⁻. Then, OH⁻ is supplied from a bulk region in the electrolyte solution S, that is, a region apart from the object surface W1 than the surface vicinity region is positioned, to the surface vicinity region due to the diffusion theory. Therefore, the concentration of OH⁻ in the surface vicinity region decreases when approaching to the object surface W1 in accordance with Fick's law.

A relationship between the oxidation rate, that is, a consumption rate of OH⁻ and a supply-rate of the OH⁻ supplied from the bulk region determines whether the supply quantity of OH⁻ in the surface vicinity region is sufficient. In this respect, according to the conventional ECMP process in which the anodization current is a constant DC current, due to lack of the supply-rate of OH⁻ in accompanied with a progress of the anodization, the supply quantity of OH⁻ in the surface vicinity region is insufficient.

In this respect, the inventors have found that the anodization current is set to be a pulsed current having ON period and OFF period and OH⁻is suppled into the surface vicinity region from the bulk region during the OFF period, whereby the concentration of OH⁻ in the surface vicinity region is recovered. Here, OFF period' refers typically to a period where an amount of current is substantially zero when the application voltage is 0V. However, this is not limited thereto, but includes a case where the application voltage allows a reverse polarity of the ON period, for example. Further, the inventors have found that the OFF period is set to be short as possible (e.g. duty ratio is 0.5 or higher), thereby preventing a total processing time from being increased while maintaining a favorable oxidation rate during the ON period.

The processing speed is influenced by not only the oxidation rate but also properties of the oxide film. Specifically, according to a conventional ECMP process, applying a constant current having relatively small current density, an oxide film having relatively high density and hardness was formed. Then, a composition of the oxide film produced by an application of the constant current corresponding to the conventional ECMP process was analyzed by a XPS apparatus. As a result, 40% of SiOC, 30% of SiO and 10% of Si₂O₃ were contained. XPS is an abbreviation of X-ray Photoelectron Spectroscopy.

In contrast, analyzing a composition of the oxide film produced by applying a pulsed current using the XPS apparatus, content of SiO was significantly increased to be greater than that of the oxide film produced by applying a constant current, while content of SiOC was significantly decreased. Further, a cross-sectional image was observed using a transmission electron microscope. As a result, a void layer was significantly generated in the oxide film produced by applying a pulsed current compared to that of the oxide film produced by applying a constant current. Further, the pulse period is set to be longer, whereby an amount of voids tend to increase. Specifically, the inventors confirmed that an oxide film was formed having easy abradability in a relatively low density using the pulsed current for the anodization current.

Considering the above result, effects obtained from application of the pulsed current will be as follows. OH⁻ is favorably supplied into the surface vicinity region to promote the anodization of SiC, thereby producing a large amount of SiO in which the degree of oxidation proceeds more than that of SiOC. The more progress the degree of oxidation of SiOC and SiO, in this order, the larger the expansion coefficient is. Hence, occurrence of voids due to an internal stress in the oxide film is promoted. Accordingly, since a greater quantity of SiO occurs, generation of the void layer occurring due to a difference of expansion coefficients between before the oxidation and after the oxidation becomes more significant. Thus, the oxide film in which a large quantity of SiO is contained and an amount of voids are increased in the void layer, has lower hardness which increases a polishing speed. Further, when many cracks are produced on the surface of the oxide film due to occurrence of voids, OH⁻ as a reactive species intrudes inside the film from the cracks, whereby the anodization may be further promoted. Thus, as an effect of pulsed anodization current, it is expected that the polishing speed is increased.

Further, as described above, when applying a constant current, it is difficult to recover OH⁻ concentration in the surface vicinity region. Hence, as the generation of the oxidation film progresses, it is difficult to maintain the anodization current. Specifically, for example, even when applying a predetermined voltage in order to supply a relatively large amount of constant current exceeding 10mA/cm², the current value rapidly increases to reach the peak value corresponding to the target value, and then immediately decreases rapidly. Moreover, even in a current application condition such as 10mA/cm² or less where it is considered that anodization can be stably performed, a part of current caused to flow may not be supplied for anodization but may become used for electrolysis of electrolyte solution S. Further, a ratio of a current supplied for the anodization to a current supplied for electrolysis varies due to a decrease in a concentration of OH⁻ in the surface vicinity region. When the anodization current varies, uniformity of the oxidation film may be degraded.

On the other hand, when applying a pulsed current, anodization current can be favorably maintained from the low current region to the high current region. Specifically, the inventors have confirmed that an extremely good effect for maintaining current is obtained with a period of 0.1 second or longer. Thus, with a use of pulsed current, anodization current is stably maintained whereby uniformity of the oxide film is improved and planarity is also improved.

Moreover, in recent years, wafer size is required to be larger so as to improve productivity. Here, electrical resistance varies depending on locations in the semiconductor wafer W. Specifically, a low resistance region referred to as a facet region may be present in the semiconductor wafer W. The larger the wafer size, the more easily the facet region is produced and the larger the size of the region is.

In this respect, according to conventional ECMP methods, if current concentrates in a facet region having low resistance, the oxidation rate in the facet region is higher than that of other regions to cause a thicker oxide film. Then, the oxide film in the facet region cannot be removed and residual film remains. Hence a state of a finished wafer surface after polishing may have a defect (i.e. oxide residue defect or a shape defect). On the other hand, when setting the speed of polishing by the surface processing pad 3 to be higher in order to avoid a residue of the oxide film in the facet region, contrarily a process-modified layer may be generated on the object surface W1.

According to the present embodiment, in the ECMP process as a polishing method, the anodization current is set to have large current density while being set as a pulsed current. Specifically, the anodization current is set to be a pulsed current having a current density of 20mA/cm².

Fig.2 shows an analysis result of a flatness of the polished surface of 6-inch wafer with an example of ECMP according to the present embodiment and an ECMP of a comparative example. The current condition of the pulsed current in the example of the embodiment is that the current density in the ON period is 30mA/cm² and the current density in the OFF period is 0mA/cm², the period is 2 sec and the duty ratio is 0.75 (i.e. ON period is 1.5 sec, OFF period is 0.5 sec). The current condition of the constant current in the comparative example is that the current density is 30mA/cm². The processing speed is 12µm/h for the pulsed current and the processing speed is 6µm for the constant current, the processing time is 10 min for both processing speed conditions. For the flatness analysis, a FlatMaster 200 XRA-W manufactured by Corning Tropel as a flatness measurement apparatus was utilized to measure SFQR and TTV. SFQR is referred to as an abbreviation of Site Front Least sQuare Range. The size of each site in the SFQR was 10mm square. The setting for the measurement was: fringe sensitivity 1.8µm, and edge exclusion amount 3mm. In Fig.2, sites having SFQR values larger than or equal to 0.3µm were shown with an oblique hatching. TTV is referred to as an abbreviation of Total Thickness Variation.

As shown in Fig.2, according to the comparative example, sites where the SQFR values are larger than or equal to 0.3µm concentrate in a region shown in right side of Fig.2. With a visual inspection, a residue of an oxide film due to a facet region was confirmed at a portion corresponding to the concentrated sites. Moreover, in a region where residual oxide film is present, a concave part having a size of 1µm was confirmed. The TTV according to the comparative example was 3.9 µm. In contrast, according to the embodiment example, such an oxide film was favorably removed and favorable flatness was confirmed. The TTV according to the embodiment example was 2.1µm. The surface roughness in the embodiment example was measured using a scanning white light interferometry New View 8300 manufactured by ZYGO Corporation and the result was Sa 0.4 nm. Thus, according to the embodiment example, even for a 6-inch wafer having a relatively large facet region, a favorable mirror surface having high flatness with neither a process-modified layer nor a residual oxide film, was obtained.

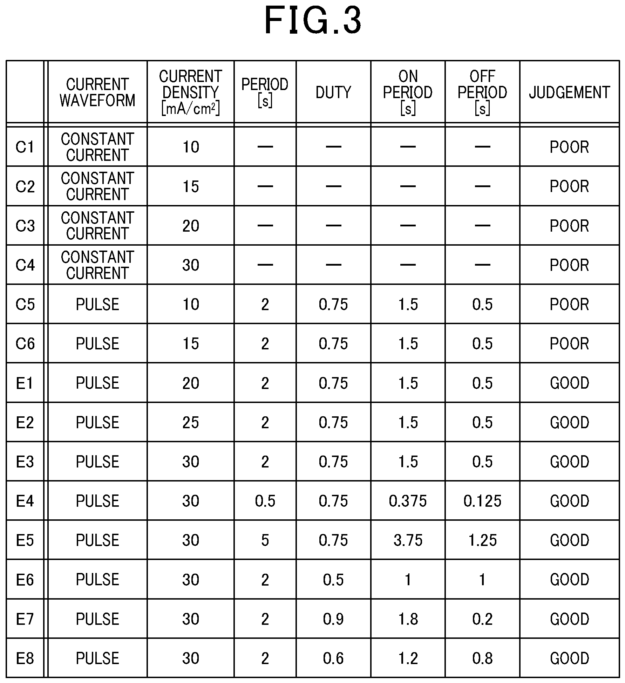

Fig.3 shows an evaluation result of an embodiment example and a comparative example in which current condition is modified in various manners. In Fig.3, C1 to C6 show the comparative example and E1 to E8 show embodiment example. Further, 'judgement' refers to an evaluation result of residual oxide film.

As shown in Fig.3, according to an example of the constant current in the comparative examples C1 to C4, even when setting the anodization current to be larger, it was not able to favorably remove the oxide film in the facet region. Further, as shown in the comparative examples C5 and C6, even when the pulsed current is used, it was not able to favorably remove the oxide film in the facet region with the current density of approximately 10mA/cm² or 15mA/cm². In contrast, according to respective embodiment examples using the pulsed current with the current density of 20mA/cm² or larger, it was able to favorably remove the oxide film under various period conditions or duty ratio conditions.

Thus, according to the present embodiment, the current density is set to be larger while setting an anodization current to be pulsed current. Hence, in the anodization process, OH⁻ is effectively supplied into the surface vicinity region, reactive species is favorably maintained, and oxide film having easy abradability and uniform with respect to the in-plane direction is formed. The oxide film having easy abradability can be smoothly polished and removed. With this, processing variation on the object surface W1 can be favorably suppressed. Further, a process-modified layer is preferably prevented from occurring while suppressing a residue of the oxide film in facet regions. Hence, according to the present embodiment, although resistance value in the semiconductor wafer W varies due to the facet regions, polishing can be favorably performed by the ECMP process. Specifically, for example, although resistance variation approximately 10 to 30mΩ/cm is present on the object surface W1 in the SiC wafer, a favorable mirror surface having high flatness was obtained without a process-modified layer and a residual oxide film. Thus, according to the present embodiment, in a surface processing method of the semiconductor wafer W being applied with an anodization, a technique capable of achieving processing characteristics more excellent than that of conventional technique can be provided. Specifically, even with a SiC wafer having a variation in the resistance value due to facet regions, an epi-ready surface in which the flatness (i.e. TTV) is less than or equal to 3µm, and a surface roughness Ra is less than or equal to 0.4nm can be completed without any process-modified layers.

### (Modification Examples)

The present disclosure is not limited to the above-described embodiments. Hence, the above-described embodiments may be appropriately modified. Hereinafter, typical modification examples will be described. In the following explanation of the modification examples, configurations different from those in the above-described embodiments will mainly be described. Further, in the above-described embodiments and the modification examples, the same reference symbols are applied to mutually the same or equivalent portions. Hence, in the description of the following modification examples, explanations for the above-described embodiments are appropriately used for the configurations having the same reference symbols in the above-described embodiments as long as no technical inconsistency is present or no specific additional explanation is required.

The present disclosure is not limited to specific configurations described in the above embodiments. That is, Fig. 1 and the description with Fig. 1 are simplified in order to explain an overall configuration and function of the surface processing apparatus 1 according to the present embodiment and is not necessarily the same as a specific configuration of apparatus actually manufactured and sold.

Specifically, for example, the above-described embodiments have a configuration in which the semiconductor wafer W is supported at the case 2 side and the surface processing pad 3 is supported capable of being rotating in an upper side of the semiconductor wafer W. However, the present disclosure is not limited to the above-described embodiments. That is, a configuration may be utilized in which a semiconductor wafer W is supported on a chuck rotatably driven by a drive apparatus 4 provided in an upper side of the case 2, and the surface processing pad 3 is supported on the case 2 side.

The electrolyte solution S may contain an etchant component. With the surface processing apparatus 1 according to the present disclosure and a surface processing method executable with this surface processing apparatus 1, the oxide film generated by anodization may be selectively removed using both of etchant and the surface processing pad 3, whereby the object surface W1 may be polished or grinded. Alternatively, the surface processing apparatus 1 according to the present disclosure and the surface processing method executable with this surface processing apparatus 1 may remove the oxide film generated by anodization using a dissolution with etchant solution or a chemical etching without using a polishing of the grinding stone layer 32 or the grinding.

Further, the configuration of the surface processing pad 3, for example, a yearn count or a material of the grinding stone layer 32 are not specifically limited. That is, detailed configuration of the surface processing pad 3 (e.g. a yearn count or a material of the grinding stone layer 32) may be appropriately selected from available configurations within a scope in which effects of the present disclosure are reliably obtained.

For the wafer size, even when the wafer size is larger than 6-inches as exemplified in the above embodiments, similar polishing speed can be obtained. Specifically, the surface processing method according to the present embodiment may preferably be applied to wafers having 1 to 8 inches wafer size, for example.

Expression of `anodization is applied' may be expressed as `anodization is utilized' .

In the above-described embodiments, elements constituting the embodiments are not necessarily required except that elements are clearly specified as necessary or theoretically necessary. Even in the case where numeric values are mentioned in the above-described embodiments, such as the number of constituents, numeric values, quantity, range or the like, it is not limited to the specific values unless it is specified as necessary or theoretically limited to specific numbers. In the case where shapes, directions, positional relationships and the like are mentioned for the constituents in the above-described embodiments, it is not limited to the shapes, directions and positional relationships except where they are clearly specified or theoretically limited to specific shapes, directions, positional relationships and the like.

The modification examples are not limited to the above-described examples. For example, a plurality of embodiments other than the above-described examples may be mutually combined as long as no technical inconsistency is present. Similarly, a plurality of modification examples may be mutually combined as long as no technical inconsistency is present.

## Claims

1. A method for processing a surface of a semiconductor wafer (W) comprising steps of:
causing a pulsed current of which the current density is larger than or equal to 20mA/cm² to flow through the semiconductor wafer as an anode in an electrolyte solution (S), thereby anodizing an object surface (W1); and
selectively removing an oxide generated on the object surface during the anodization.

2. The method according to claim 1,
wherein
a period of the pulsed current is from 0.5 sec to 5.0 sec and a duty ratio of the pulsed current is from 0.5 to 0.9.

3. The method according to claim 1 or 2,
wherein
in a state where a surface processing pad (3) having a grinding stone layer (32) is disposed such that the grinding stone layer faces the object surface, an oxide is selectively removed by the grinding stone layer.

4. The method according to claim 3,
wherein
polishing is used for selectively removing an oxide by the griding stone layer.

5. The method according to any one of claims 1 to 4,
wherein
the oxide is selectively removed by a solution in which the oxide is soluble.

6. The method according to any one of claims 1 to 5,
wherein
the semiconductor wafer is a SiC wafer.
